# EUROPÄISCHE PATENTSCHRIFT

(11) **EP 2 442 018 B1**
(45) Veröffentlichungstag und Bekanntmachung des Hinweises auf die Patenterteilung: **05.11.2014**
(21) Anmeldenummer: 11182191.4
(22) Anmeldetag: 21.09.2011
(51) Int. Cl.: F21S 8/10, B60Q 1/26, H05F 3/02, H05K 1/02, H05K 1/11

(54) **Kraftfahrzeugleuchte**
Motor vehicle light
Lampe de véhicule automobile

(30) Priorität: 12.10.2010 DE 102010048236
(43) Veröffentlichungstag der Anmeldung: 18.04.2012
(73) Patentinhaber: odelo GmbH, 71409 Schwaikheim (DE)
(72) Erfinder: Schneider, Robert, 89198 Westerstetten (DE); Hofmann, Heinz-Dieter, 73779 Deizisau (DE)
(74) Vertreter: Benninger, Johannes

(56) Entgegenhaltungen:
- DE-A1- 19 703 404
- DE-A1- 19 718 374
- FR-A1- 2 816 035
- US-A- 4 223 368
- US-A- 4 334 259
- US-A- 5 536 174
- US-A- 6 156 235

## Beschreibung

Die Erfindung betrifft eine Kraftfahrzeugleuchte gemäß dem Oberbegriff des Anspruchs 1.

Eine Kraftfahrzeugleuchte erfüllt je nach Ausgestaltung eine oder mehrere Aufgaben bzw. Funktionen, wie beispielsweise bei einer Ausgestaltung als Scheinwerfer eine die Fahrbahn ausleuchtende Funktion, oder bei einer Ausgestaltung als Signalleuchte eine Signalfunktion, wie beispielsweise zur Fahrtrichtungsanzeige oder Anzeige einer Bremstätigkeit, oder einer Sicherstellung einer Sichtbarkeit des Kraftfahrzeugs bei Tag und/oder Nacht, wie etwa bei einer Ausgestaltung als Tagfahrleuchte. Beispiele für Kraftfahrzeugleuchten sind am Fahrzeugbug, an den Fahrzeugflanken und/oder an den Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine Kraftfahrzeugleuchte besteht im Wesentlichen aus einem Gehäuse, einem darin angeordneten Leuchtmittel, gegebenenfalls einem typischerweise hinter dem Leuchtmittel in dem Gehäuse angeordneten Reflektor und/oder einem vor dem Leuchtmittel angeordnete Optikelement, wie etwa einer Linse, einem Rinnenkonzentrator, z.B. einer Parabolrinne (CPC; Compound Parabolic Concentrator) oder dergleichen zur Ausformung einer definierten Abstrahlcharakteristik, sowie einer das Leuchtmittel und gegebenenfalls den Reflektor bzw. das Optikelement gegen Witterungseinflüsse schützenden, kurz auch als Lichtscheibe bezeichneten transparenten Abdeckung. Die Lichtscheibe umschließt gemeinsam mit dem Gehäuse einen das Leuchtmittel und gegebenenfalls den Reflektor aufnehmenden Leuchteninnenraum. In dem Leuchteninnenraum kann zwischen Leuchtmittel und Lichtscheibe eine Optikscheibe angeordnet sein, welche beispielsweise eine bestimmte Struktur und/oder Maskierung aufweisen kann, beispielsweise um bei einer klaren, für einen Betrachter eine Tiefenwirkung bewirkenden Lichtscheibe das Leuchtmittel zu kaschieren. Das Gehäuse bzw. der Leuchteninnenraum kann dabei in mehrere Kammern mit jeweils eigenen Leuchtmitteln, eventuell Reflektoren und/oder Optikscheiben, sowie gegebenenfalls Lichtscheiben unterteilt sein, von denen mehrere Kammern gleiche oder jede Kammer eine andere der oben beschriebenen Funktionen erfüllen kann.

Als Lichtquelle von Leuchtmitteln für Kraftfahrzeugleuchten kommen unter anderem wegen ihres geringen Stromverbrauchs vermehrt Leuchtdioden zum Einsatz. Diese bestehen aus mindestens einem Lichtemittierende-Diode-Halbleiter-Chip, kurz LED-Chip, sowie wenigstens einer beispielsweise durch Spritzgießen angeformten, den mindestens einen LED-Chip ganz oder teilweise umhüllenden Primäroptik. Auch sind Kraftfahrzeugleuchten bekannt, in denen reine LED-Chips ohne angeformte Primäroptiken zum Einsatz kommen. Im Folgenden wird deshalb der Einfachheit halber nicht mehr zwischen Leuchtdiode und LED-Chip unterschieden und statt dessen einheitlich der Begriff LED stellvertretend für beide Ausgestaltungen verwendet, es sei denn, es ist explizit etwas anderes erwähnt. Herausragende Eigenschaften von LEDs im Vergleich zu anderen, konventionellen Lichtquellen von Leuchtmitteln sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von LEDs als Lichtquelle von Leuchtmitteln besonders kompakte Kraftfahrzeugleuchten verwirklicht werden, die an fast jede nur erdenkliche Einbausituation angepasst sein können.

Die LEDs sind zur Verwendung als Lichtquellen von Leuchtmitteln für Kraftfahrzeugleuchten einzeln oder gruppenweise auf mindestens einem mit Leiterbahnen zur elektrischen Kontaktierung versehenen Leuchtmittelträger angeordnet, welcher im Leuchteninnenraum so platziert ist, dass das von den LEDs ausgestrahlte Licht möglichst verlustarm durch die wenigstens eine den Leuchteninnenraum abschließende Lichtscheibe hindurch aus der Kraftfahrzeugleuchte austritt. Bei dem Leuchtmittelträger handelt es sich im einfachsten Fall um eine oder mehrere im Leuchteninnenraum angeordnete, ebene (2-D) Platinen oder so genannte Printed Circuit Boards (PCB), im aufwändigsten Fall um einen in Form eines oder mehrerer spritzgegossener Schaltungsträger (MID; Molded-Interconnect-Device) ausgeführten, komplex geformten (3-D) und mit integrierten Leiterbahnen ausgeführten Leuchtmittelträger mit integrierter mechanischer und elektronischer Funktion.

Zum Betrieb vom LEDs als Lichtquellen für Leuchtmittel von Kraftfahrzeugleuchten können eine oder mehrere mehr oder minder komplexe elektronische Steuerschaltungen vorgesehen sein die beispielsweise auf einem oder mehreren im Leuchteninnenraum untergebrachten Leuchtmittelträgern angeordnet sein können.

Ein einfaches Beispiel für eine elektronische Steuerschaltung betrifft die Angleichung unterschiedlicher Helligkeiten einzelner LEDs oder von LED-Strängen innerhalb einer Gruppe gemeinsam betriebener, auf einem oder mehreren Leuchtmittelträgern angeordneter LEDs. Eine solche elektronische Steuerschaltung besteht aus mindestens einem oder mehreren Vorwiderständen zur Anpassung der Vorwärtsspannung der LEDs an das Bordnetz. Beispielsweise ist bekannt, die LEDs im so genannten Binning nach Vorwärtsspannung und Intensität zu sortieren. Um Unterschiede zwischen mehreren LED-Strängen auszugleichen, die jeweils aus in Reihe geschalteten LEDs gleicher Vorwärtsspannung und Intensität bestehen, und um eine homogene Helligkeitsverteilung der benachbarten LED-Stränge aus LEDs mit unterschiedlicher Vorwärtsspannung und Intensität zu erhalten, wird zumindest jeder LED-Strang mit einem anderen Vorwiderstand versehen.

LEDs bedürfen darüber hinaus beim Einsatz als Lichtquelle insbesondere in Kraftfahrzeugleuchten einer separaten Ausfallerkennung. Dies ist bedingt durch die geringe Leistungsaufnahme von LEDs im Allgemeinen. Beispielsweise ist ein in einem Kraftfahrzeug untergebrachtes Steuergerät nicht in der Lage, eine dem Ausfall einer oder weniger LEDs entsprechende Änderung der Leistungsentnahme aus dem Bordnetz zu erkennen, da eine hieraus resultierende Bordnetzspannungsänderung unterhalb der im normalen Betrieb eines Kraftfahrzeugs auftretenden Bordnetzspannungssschwankung liegt. Eine beispielsweise in der Kraftfahrzeugleuchte untergebrachte elektronische Schaltungsanordnung zur Ausfallerkennung erfasst den Ausfall einer oder mehrerer Leuchtdioden in der Kraftfahrzeugleuchte z.B. mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können LEDs weiterer elektronischer Steuerschaltungen bedürfen. Beispiele hierfür sind elektronische Steuerschaltungen:
- zur Regelung und/oder Steuerung der Helligkeit bzw. Leuchtkraft der LEDs, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der LEDs z.B. vor einer Überspannung des Bordnetzes oder vor fehlerhafter Polung, beispielsweise umfassend eine oder mehrere Zenerdioden,

Zusammengefasst muss für fast alle LED-Anwendungen eine mehr oder minder umfangreiche, für die speziellen LEDs ausgelegte elektronische Steuerschaltung z.B. auf den mindestens einen Leuchtmittelträger aufgebracht werden. Die elektronische Steuerschaltung umfasst im einfachsten Fall einen Vorwiderstand und eine Schutzdiode, kann aber je nach Anwendung auch wesentlich mehr Elektronikbauteile enthalten, wie z.B. Kondensatoren, Ferrite, etc.

Durch elektrostatische Aufladungen auf elektrisch isolierenden Kunststoffteilen einer Heckleuchte, z.B. Gehäuse oder Lichtscheibe, aber auch einer Verpackung, wie etwa einer Folie oder einem Kunststoffbehälter, können im Leuchteninnenraum infolge der Influenzwirkung Potentialunterschiede zwischen den elektrisch leitfähigen Komponenten erzeugt werden.

Bei den elektrisch leitfähigen Komponenten handelt es sich beispielsweise um die Metallmasse des metallischen oder metallisierten Reflektors und die Leiterbahnen des mindestens einen Leuchtmittelträgers.

Diese Potentialunterschiede haben elektrische Spannungen zur Folge, die sich schlagartig in Form eines elektrischen Überschlags entladen können. Solche elektrostatischen Entladungen (ESD) können die Zerstörung elektronischer Bauelemente z.B. der elektronischen Steuerschaltungen oder der LEDs selbst zur Folge haben.

Um das Problem der Zerstörung elektronischer Bauelemente durch ESD zu beheben ist bekannt, eine elektrische Verbindung zwischen zumindest einigen der elektrisch leitfähigen Komponenten herzustellen. Durch elektrische Verbindung der metallischen bzw. metallisierten Komponenten, wie etwa Reflektorbedampfung und der mit Masse verbundenen Leiterbahnen des bzw. der Leuchtmittelträger im Leuchteninnenraum wird erreicht, dass auch bei Einwirkung eines äußeren elektrostatischen Feldes alle leitfähigen Innenteile auf demselben Potential liegen. Dadurch können keine Überschläge entstehen und Schäden verursacht durch ESD, so genannte ESD-Schäden, werden wirksam vermieden.

Bisher werden zur Verhinderung von ESD-Schäden benötigte elektrische Verbindungen zwischen zumindest einigen der elektrisch leitfähigen Komponenten im Leuchteninnenraum von Kraftfahrzeugleuchten durch direkte Ankontaktierung der metallischen bzw. metallisierten Reflektorfläche mit Hilfe einer Kontaktklammer und eines zusätzlichen Kabels mit Stecker im Kabelsatz hergestellt.

Nachteilig bei dieser Lösung sind:
- ein Bedarf zusätzlicher Bauteile, wie etwa Klammer, Kabel, Stecker,
- ein zusätzlicher, zeit- und kostenaufwändiger Montageaufwand z.B. um Klammer und Stecker zu montieren, sowie
- die Gefahr einer Fehlmontage.

Der Erfindung liegt die Aufgabe zugrunde, eine Kraftfahrzeugleuchte mit hohem Schutz der im Leuchteninnenraum beherbergten elektronischen Bauelemente und/oder elektronischen Steuerschaltungen und/oder LEDs vor ESD-Schäden zu entwickeln, welche zeitsparend und kostengünstig hergestellt werden kann.

Die Aufgabe wird gelöst durch eine Kraftfahrzeugleuchte mit den Merkmalen des Anspruchs 1.

Demnach ist eine Kraftfahrzeugleuchte mit einem durch ein Leuchtengehäuse und eine dieses abschließende Lichtscheibe umschlossenen Leuchteninnenraum vorgesehen. Der Leuchteninnenraum beherbergt wenigstens ein elektronisches Bauelement. Das mindestens eine Bauelement kann Teil einer elektronischen Schaltung sein, eine elektronische Schaltung umfassen oder von einer elektronischen Schaltung umfasst sein. Das mindestens eine Bauelement ist auf wenigstens einem mit Leiterbahnen versehenen Leuchtmittelträger angeordnet und mit zumindest einigen, beispielsweise zwei, der Leiterbahnen elektrisch kontaktiert. Auf dem Leuchtmittelträger sind bevorzugt eine oder mehrere LEDs als Lichtquellen angeordnet und ebenfalls mit zumindest einigen, beispielsweise zwei, der Leiterbahnen elektrisch kontaktiert. Wichtig ist hierbei hervorzuheben, dass eine als Lichtquelle vorgesehene LED ein zuvor erwähntes elektronisches Bauelement darstellen kann. Darüber hinaus beherbergt der Leuchteninnenraum wenigstens eine von den Leiterbahnen des mindestens einen Leuchtmittelträgers verschiedene, elektrisch leitfähige Fläche.

Die mindestens eine von den Leiterbahnen des mindestens einen Leuchtmittelträgers verschiedene, elektrisch leitfähige Fläche kann beispielsweise durch eine Beschichtung, beispielsweise durch Bedampfen oder dergleichen elektrisch leitfähig hergestellt sein. Vorzugsweise umfasst die mindestens eine von den Leiterbahnen des mindestens einen Leuchtmittelträgers verschiedene elektrisch leitfähige Fläche eine beispielsweise für einen Reflektor vorgesehene oder einen solchen bildende reflektierende Beschichtung. Beispielsweise kann es sich bei der mindestens einen von den Leiterbahnen des mindestens einen Leuchtmittelträgers verschiedenen elektrisch leitfähigen Fläche um eine beispielsweise für einen Reflektor vorgesehene oder einen solchen bildende reflektierende Beschichtung handeln. Umfasst die beispielsweise für einen Reflektor vorgesehene oder einen solchen bildende Beschichtung neben einer reflektierenden Beschichtung auch noch eine z.B. eine elektrisch leitfähige Metallisierung passivierende Schicht, so ist letztere vorzugsweise nicht Bestandteil der mindestens einen von den Leiterbahnen des mindestens einen Leuchtmittelträgers verschiedenen elektrisch leitfähigen Fläche.

Beispielsweise kann es sich bei der mindestens einen von den Leiterbahnen des mindestens einen Leuchtmittelträgers verschiedenen, elektrisch leitfähigen Fläche um die reflektierende Beschichtung eines im Leuchteninnenraum beherbergten Reflektors handeln, aber auch um eine einen Reflektor bildende, auf der dem Leuchteninnenraum zugewandten Oberfläche des Leuchtengehäuses angebrachte reflektierende Beschichtung. Auch kann die mindestens eine von den Leiterbahnen des mindestens einen Leuchtmittelträgers verschiedene, elektrisch leitfähige Fläche die Oberfläche eines aus einem elektrisch leitfähigen Werkstoff hergestellten und im Leuchteninnenraum beherbergten Bauteils der Kraftfahrzeugleuchte sein.

Um das wenigstens eine elektronischen Bauelement und/oder die wenigstens eine elektronische Steuerschaltung und/oder die wenigstens eine LED vor ESD-Schäden zu schützen, steht die zumindest eine von den Leiterbahnen des mindestens einen Leuchtmittelträgers verschiedene elektrisch leitfähige Fläche mit zumindest einer Leiterbahn des mindestens einen Leuchtmittelträgers in elektrischem Kontakt.

Die Kraftfahrzeugleuchte kennzeichnet sich durch mindestens ein elastisches, elektrisch leitfähiges Pad aus, welches den elektrischen Kontakt zwischen der zumindest einen von den Leiterbahnen des mindestens einen Leuchtmittelträgers verschiedenen elektrisch leitfähigen Fläche und zumindest einer Leiterbahn des mindestens einen Leuchtmittelträgers herstellt.

Das Pad besorgt hierbei den elektrischen Kontakt. Das Pad ist hierbei zum Toleranzausgleich und zur Sicherstellung eines dauerhaften elektrischen Kontakts elastisch ausgeführt.

Bei dem Pad kann es sich beispielsweise um ein von einer leitfähigen Umhüllung umgebenen elastischen Werkstoff handeln. Die elektrisch leitfähige Umhüllung kann beispielsweise eine Metallfolie oder ein Metallgewebe umfassen. Bei dem elastischen Werkstoff kann es sich um ein Elastomer und/oder einen Schaum und/oder Schwamm handeln. Das Pad kann darüber hinaus eine auf wenigstens einer Seite aufgebrachte elektrisch leitfähige Klebeschicht umfassen, welche der elektrisch leitfähigen Befestigung des Pads an zumindest einer Leiterbahn des Leuchtmittelträgers oder an der hiervon verschiedenen elektrischen Fläche zur Herstellung des elektrischen Kontakts zwischen diesen dient. Anstelle eines umhüllten elastischen Werkstoffs kann das Pad einen elektrisch leitfähigen, elastischen Werkstoff umfassen. Dieser kann, muss aber nicht, von der Umhüllung umgeben sein. Beispielsweise genügt es, den elektrisch leitfähigen, elastischen Werkstoff einseitig, vorzugsweise auf der Seite, die nicht der Befestigung dient und nicht mit der elektrisch leitfähigen Klebeschicht versehen ist, sondern vielmehr der gegenüberliegenden elektrisch leitfähigen Fläche zugewandt ist, mit einer Metallfolie oder einem Metallgewebe zu versehen, als Schutz gegen Abrieb und Verschleiß. Im einfachsten Fall kann es sich bei dem elektrisch leitfähigen Pad um ein elastisches, elektrisch leitfähiges Flies handeln, das mit elektrisch leitfähigem Klebstoff entweder auf wenigstens einer der Leiterbahnen des Leuchtmittelträgers oder auf der dieser im zusammengebauten Zustand der Kraftfahrzeugleuchte gegenüber liegenden, elektrisch leitfähigen Fläche befestigt ist. Das Flies kann beispielsweise filzartig aus Metalldrähten hergestellt sein.

Durch die Elastizität des Pads können Zwischenräume zwischen der Leiterbahn und der elektrisch leitfähigen Fläche überbrückt werden. Darüber hinaus kann dadurch ein ständiger Anpressdruck erzeugt und damit ein zuverlässig hergestellter elektrischer Kontakt sichergestellt werden.

Das Pad ist bevorzugt derart angeordnet, dass bei der Montage des zumindest einen die wenigstens eine elektrisch leitfähige Fläche umfassenden Bauteils und des mindestens einen Leuchtmittelträgers der elektrische Kontakt zwangsweise hergestellt wird. Eine derart ausgeführte Kraftfahrzeugleuchte ist gekennzeichnet durch eine kabel-, klammer- und steckerfreie, zwangsweise Herstellung der elektrischen Kontaktierung bzw. zwangsweise hergestellte elektrische Kontaktierung der zumindest einen von den Leiterbahnen des mindestens einen Leuchtmittelträgers verschiedenen elektrisch leitfähigen Fläche mit zumindest einer Leiterbahn des mindestens einen Leuchtmittelträgers beim Zusammenfügen beispielsweise der Komponenten Lichtscheibe, Leuchtengehäuse, Leuchtmittelträger sowie gegebenenfalls Reflektor der Kraftfahrzeug leuchte.

Es ist ersichtlich, dass die Erfindung bevorzugt eine zwangsweise Herstellung des elektrischen Kontakts zwischen wenigstens einer von den Leiterbahnen des mindestens einen Leuchtmittelträgers unterschiedlichen elektrisch leitfähigen Fläche im Leuchteninnenraum z.B. der metallischen bzw. metallisierten Oberfläche eines gegebenenfalls vorgesehenen Reflektors und z.B. der Kupfermasse der Leiterbahnen des Leuchtmittelträgers zum Zwecke des Potentialausgleichs vorsieht.

Insbesondere kann die Erfindung dadurch verwirklicht sein, dass eine auf der Vorderseite eines Reflektors der Kraftfahrzeugleuchte zur Herstellung einer reflektierenden Oberfläche vorgesehene, metallische, elektrisch leitfähige Beschichtung an einer oder mehreren Stellen auf eine von der Vorderseite verschiedene, vorzugsweise von außerhalb der Kraftfahrzeugleuchte durch die Lichtscheibe hindurch nicht sichtbare bzw. außerhalb des Sichtbereichs liegende Seite des Reflektors gezogen ist, welche eine von den Leiterbahnen des mindestens einen Leuchtmittelträgers verschiedene elektrisch leitfähige Fläche bildet. Diese elektrisch leitfähige Fläche ist in einem Bereich vorgesehen, in dem im zusammengebauten Zustand der Kraftfahrzeugleuchte der Leuchtmittelträger angeordnet ist. Das elektrisch leitfähige Pad ist kann auf dieser elektrisch leitfähigen Fläche elektrisch leitend angeordnet und befestigt sein. Beim Einbau der Leiterplatte stellt es den elektrischen Kontakt mit einer dem Pad gegenüberliegenden Leiterbahn des Leuchtmittelträgers her. Alternativ kann das elektrisch leitfähige Pad auf wenigstens einer Leiterbahn des Leuchtmittelträgers elektrisch leitfähig angeordnet und befestigt sein und beim Zusammenbau mit der elektrisch leitfähigen Fläche in Kontakt kommen.

Eine vorteilhafte Ausgestaltung der Erfindung sieht beispielsweise vor, dass eine beispielsweise durch eine Reflektor-Metallisierung gebildete und von den Leiterbahnen des mindestens einen Leuchtmittelträgers verschiedene elektrisch leitfähige Fläche direkt und ohne Verwendung eines zusätzlichen Kabels, einer Klammer oder eines Steckers oder einer elektrischen Steckverbindung, d.h. frei von Kabeln, Klammern und Steckern, zwangsweise bei Montage des Leuchtmittelträgers ankontaktiert wird.

Bei der mindestens einen elektrisch leitfähigen Fläche kann es sich beispielsweise um eine metallische bzw. metallisierte Oberfläche z.B. eines Reflektors handeln.

Der Leuchtmittelträger kann beispielsweise als eine beispielsweise in Form eines Printed-Circuit-Boards (PCB) ausgeführten Platine oder als ein in MID-Technik hergestellter, spritzgegossener Schaltungsträger ausgeführt sein. Der Leuchtmittelträger kann ebenfalls zumindest zum Teil im Leuchteninnenraum beherbergt sein. Ebenfalls ist denkbar, dass der Leuchtmittelträger einen Teil des Leuchtengehäuses bildet, dieses umfasst oder von diesem umfasst wird. Beispielsweise kann der Leuchtmittelträger in das Leuchtengehäuse integriert sein.

Bei der mindestens einen Leiterbahn des zumindest einen Leuchtmittelträgers kann es sich beispielsweise um die Kupfermasse einer oder mehrerer Leiterbahnen des beispielsweise als Leiterplatte bzw. PCB oder als spritzgegossener Schaltungsträger ausgeführten Leuchtmittelträgers handeln.

Die zwangsweise Herstellung des elektrischen Kontakts zwischen der beispielsweise durch eine metallische bzw. metallisierte Oberfläche z.B. eines Reflektors gebildete elektrisch leitfähigen Fläche und der beispielsweise durch die Kupfermasse des beispielsweise als Leiterplatte bzw. PCB ausgeführten Leuchtmittelträgers gebildeten Leiterbahn erfolgt hierbei bevorzugt durch direkte Berührung der bedampften Oberfläche des Reflektors und dem Leuchtmittelträger beim Zusammenbau der Kraftfahrzeugleuchte. Hierzu kann vorzugsweise an einer geeigneten Stelle auf dem Leuchtmittelträger oder auf der elektrisch leitfähigen Fläche mindestens ein Pad aus leitfähigem und elastischem Werkstoff durch z.B. Aufkleben angeordnet und mit der mindestens einen Leiterbahn des Leuchtmittelträgers oder mit der mindestens einen elektrisch leitfähigen Fläche elektrisch verbunden sein. Bei der Montage des Leuchtmittelträgers erfolgt die Berührung und damit die eine Herstellung des elektrischen Kontakts kennzeichnende elektrische Verbindung zwangsweise.

Das Pad kann aus einem elektrisch leitfähigen Schaum bzw. Schaumstoff oder aus einem aufgeschäumten, elektrisch leitfähigen Werkstoff hergestellt sein oder einen solchen umfassen.

Besonders bevorzugt ist der Werkstoff des Pads dauerelastisch oder umfasst das Pad einen solchen Werkstoff.

Auch ist denkbar, das Pad zumindest zum Teil aus einer elektrisch leitfähigen Paste herzustellen, vorzugsweise aus einer dauerelastisch oder dauerelastisch aushärtenden elektrisch leitfähigen Paste.

Auch kann ein metallisierter, dauerelastischer Werkstoff für das Pad verwendet werden, z.B. ein metallisiertes Elastomer, ein metallisiertes Gummi oder ein anderer, metallisierter, gummiartiger Werkstoff. Alternativ kann das Pad zumindest teilweise einen solchen Werkstoff umfassen.

Grundsätzlich ist auch denkbar, eine Feder bzw. Kontaktfeder zur Herstellung des elektrischen Kontakts vorzusehen. Im Vergleich zu einer Verwendung einer Feder bzw. Kontaktfeder kommt es durch Verwendung eines oder mehrerer Pads, insbesondere in einer der angeführten Ausgestaltungen des Pads, nicht zu einem Durchscheuern der elektrisch leitfähigen Fläche oder der Leiterbahn und dadurch auch nicht zu einer Aufhebung des elektrischen Kontakts z.B. über die Lebensdauer einer Kraftfahrzeugleuchte hinweg.

Das Pad kann am Leuchtmittelträger bzw. an einer oder mehreren Leiterbahnen des Leuchtmittelträgers oder an der elektrisch leitfähigen Fläche befestigt oder mit einer solchen elektrisch leitend verbunden sein.

Eine zugehörige, dem Pad zugeordnete und mit diesem zusammenwirkende Kontaktfläche kann am jeweils anderen Bauteil vorgesehen sein. Je nachdem, ob das Pad am Leuchtmittelträger oder an der elektrisch leitfähigen Fläche vorgesehen ist, ist die Kontaktfläche dabei mit mindestens einer elektrisch leitfähigen Fläche oder mit mindestens einer Leiterbahn des Leuchtmittelträgers elektrisch verbunden.

Die elektrische Verbindung des Pads mit einer elektrisch leitfähigen Fläche oder mit mindestens einer Leiterbahn des Leuchtmittelträgers sieht bevorzugt eine Klebeverbindung mittels eines elektrisch leitfähigen Klebstoffs vor, der beispielsweise in Form einer elektrisch leitfähigen Klebeschicht auf einer Seite des Pads aufgebracht sein kann. Hierdurch kann das Pad mit der elektrisch leitfähigen Klebeschicht vorkonfiguriert hergestellt werden und anschließend in einem einzigen Arbeitsgang einfach und zeitsparend befestigt und gleichzeitig elektrisch verbunden werden.

An einer der dem Pad gegenüberliegenden und mit diesem zusammenwirkenden Kontaktfläche kann mindestens ein dem Pad zugeordneter Vorsprung vorgesehen sein, welcher in montiertem Zustand der Kraftfahrzeugleuchte das Pad eindrückt oder in dieses einschneidet, zur Sicherstellung der elektrischen Kontaktierung.

Dabei können mehrere Vorsprünge je Pad vorgesehen sein.

Auch mehrere Pads je elektrischer Kontaktierung einer Leiterbahn und einer elektrisch leitfähigen Fläche sind denkbar.

Mehrere mit mindestens einem Pad zusammenwirkende Vorsprünge dienen der Schaffung einer Redundanz, um die Kontaktsicherheit zu erhöhen.

Das Pad ist vorzugsweise mit einer für den elektrischen Betrieb wenigstens einer Lichtquelle der Kraftfahrzeugleuchte vorgesehenen Leiterbahn des Leuchtmittelträgers verbunden, z.B. mit einer geerdeten bzw. Masse führenden Leiterbahn.

Die Kraftfahrzeugleuchte kann beispielsweise als Kraftfahrzeugheckleuchte oder als Tagfahrleuchte ausgebildet sein.

Vorteile der Erfindung gegenüber dem Stand der Technik ergeben sich unter Anderem durch eine vereinfachte Montage durch den Entfall von nach dem Stand der Technik zur Herstellung des elektrischen Kontakts erforderlichen Kabeln, Klammern und Steckern. Weitere Vorteile ergeben sich dadurch, dass kein zusätzlicher Montageaufwand erforderlich ist, um die elektrische Kontaktierung herzustellen. Darüber hinaus ist ein elastisches, leitfähiges Pad kostengünstiger in seiner Herstellung, als die nach dme Stand der Technik für die elektrische Kontaktierung vorgesehenen Stecker und/oder Klammern sowie Kabel. Hierdurch ergibt sich ein geringerer Teilepreis für das mindestens eine Pad im Vergleich zu Stecker und/oder Klammer sowie Kabel. Durch die Einsparung der nach dem Stand der Technik für die Montage von Stecker und/oder Klammer sowie Kabel benötigten Montagezeit sowie durch die geringeren Herstellungskosten für ein Pad im Vergleich zu Steckern und/oder Klammern sowie Kabel kann eine erfindungsgemäße Kraftfahrzeugleuchte wesentlich kostengünstiger hergestellt werden, als bislang nach dem Stand der Technik möglich.

Die Verwendung eines oder mehrerer Pads anstelle von Steckern und/oder Klammern sowie Kabeln für die elektrische Kontaktierung hat außerdem eine höhere Prozesssicherheit während der Montage z.B. durch die mittels des Pads mögliche Zwangskontaktierung zur Folge. Die höhere Prozesssicherheit hat eine geringere Fehlerquote und damit einen geringeren Ausschuss sowie geringeren Ausfall durch fehlerhafte, mangelhafte oder nicht vorhandene elektrische Kontaktierung zur Folge. Durch die Zwangskontaktierung ist eine Fehlmontage nicht möglich. Dadurch wird ein nochmals geringerer Ausschuss mit insgesamt geringeren Herstellungskosten für die erfindungsgemäße Kraftfahrzeugleuchte im Vergleich zu einer Kraftfahrzeugleuchte nach dem Stand der Technik erreicht.

Die Erfindung wird nachfolgend anhand von in der Zeichnung dargestellten Ausführungsbeispielen näher erläutert. Darin bezeichnen gleiche Bezugszeichen gleiche oder gleich wirkende Elemente.

Es zeigen in schematischer Darstellung:
- Fig. 1: ein Leuchtengehäuse einer Kraftfahrzeugleuchte von dessen dem Leuchteninnenraum zugewandter Seite her in perspektivischer Ansicht.
- Fig. 2: eine Draufsicht auf einen Leuchtmittelträger einer Kraftfahrzeugleuchte von dessen der dem Leuchteninnenraum zugewandter Seite des Leuchtengehäuses aus Fig. 1 zugewandter Rückseite her.
- Fig. 3: das Leuchtengehäuse aus Fig. 1 mit dem darin montierten Leuchtmittelträger aus Fig. 2 von dessen seiner dem Betrachter abgewandten Rückseite gegenüberliegenden Vorderseite her in perspektivischer Ansicht.
- Fig. 4: einen Querschnitt entlang der Linie A - A aus Fig. 3.
- Fig. 5: das Leuchtengehäuse aus Fig. 1 mit einer darauf durch eine reflektierende Beschichtung hergestellten elektrisch leitfähigen Fläche in zwei verschiedenen perspektivischen Ansichten.

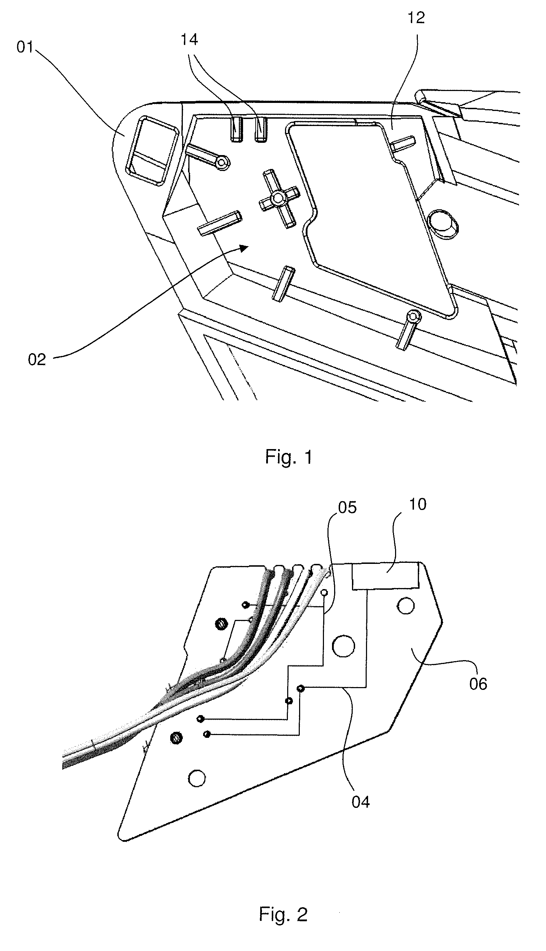

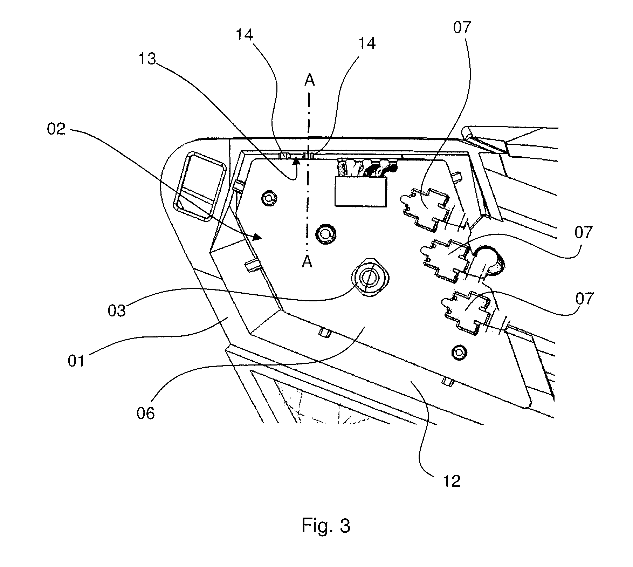

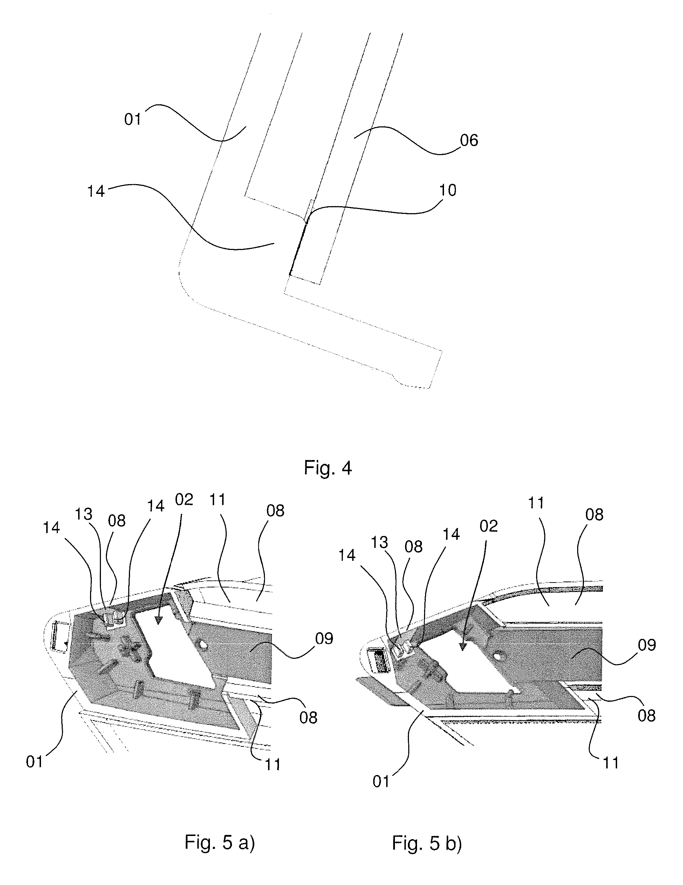

Eine Kraftfahrzeugleuchte umfasst zumindest einen durch ein in den Fig. 1, Fig. 3, Fig. 4, Fig. 5a) und Fig. 5b) dargestelltes Leuchtengehäuse 01 und eine nicht näher dargestellte, das Leuchtengehäuse 01 abschließende Lichtscheibe umschlossenen Leuchteninnenraum 02. Der Leuchteninnenraum 02 beherbergt wenigstens ein elektronisches Bauelement 03, das auf wenigstens einem in den Fig. 2, Fig. 3 und Fig. 4 dargestellten, mit Leiterbahnen 04, 05 versehenen Leuchtmittelträger 06 angeordnet und elektrisch kontaktiert ist. Das wenigstens eine Bauelement 03 kann Teil einer elektronischen Schaltung sein, eine elektronische Schaltung umfassen oder von einer elektronischen Schaltung umfasst sein. Auf dem Leuchtmittelträger 06 können darüber hinaus eine oder mehrere LEDs 07 als Lichtquellen zumindest einer Lichtfunktion der Kraftfahrzeugleuchte angeordnet und elektrisch kontaktiert sein.

Die LEDs 07 umfassen jeweils mindestens einen LED-Chip. Gegebenenfalls können sie eine beispielsweise durch Spritzgießen angeformte, den LED-Chip ganz oder teilweise umhüllende Primäroptik aufweisen.

Der Leuchtmittelträger 06 kann wie in den Fig. 2, Fig. 3 und Fig. 4 dargestellt als eine Platine ausgeführt sein. Ebenfalls ist denkbar, den Leuchtmittelträger 06 als einen in MID-Technik hergestellten, spritzgegossenen Schaltungsträger auszuführen.

Der Leuchteninnenraum 02 beherbergt darüber hinaus wenigstens eine in den Fig. 5a) und Fig. 5b) dargestellte, von den Leiterbahnen 04, 05 des mindestens einen Leuchtmittelträgers 06 verschiedene, elektrisch leitfähige Fläche 08. Die wenigstens eine elektrisch leitfähige Fläche 08 ist in den Fig. 5a) und Fig. 5b) hell dargestellt, im Gegensatz zu einer dort dunkel dargestellten, elektrisch nicht leitenden Fläche 09.

Um das wenigstens eine elektronischen Bauelement 03 und/oder die wenigstens eine elektronische Steuerschaltung und/oder die wenigstens eine LED 07 vor ESD-Schäden zu schützen, steht die zumindest eine von den Leiterbahnen 04, 05 des mindestens einen Leuchtmittelträgers 06 verschiedene elektrisch leitfähige Fläche 08 mit zumindest einer Leiterbahn 04, 05 des mindestens einen Leuchtmittelträgers 06 in elektrischem Kontakt.

Mindestens ein in den Fig. 2 und Fig. 4 dargestelltes Pad 10 aus einem elastischen, elektrisch leitfähigen Werkstoff besorgt den elektrischen Kontakt der zumindest einen von den Leiterbahnen 04, 05 des mindestens einen Leuchtmittelträgers 06 verschiedenen elektrisch leitfähigen Fläche 08 mit zumindest einer Leiterbahn 04, 05 des mindestens einen Leuchtmittelträgers 06. Der Werkstoff des Pads 10 kann beispielsweise dauerelastisch oder dauerelastisch aushärtend sein.

Das Pad 10 ist bevorzugt derart angeordnet, dass bei der Montage eines zumindest eine elektrisch leitfähige Fläche 08 umfassenden Bauteils, hier dem Leuchtengehäuse 01, und des mindestens einen Leuchtmittelträgers 06 der elektrische Kontakt zwangsweise hergestellt wird.

Die mindestens eine von den Leiterbahnen 04, 05 des mindestens einen Leuchtmittelträgers 06 verschiedene elektrisch leitfähige Fläche 08 umfasst beispielsweise eine Beschichtung. Bei der Beschichtung handelt es sich bevorzugt um eine für einen Reflektor 11 vorgesehene oder einen solchen bildende reflektierende Beschichtung.

Bei der in den Fig. 5a) und Fig. 5b) dargestellten mindestens einen von den Leiterbahnen 04, 05 des mindestens einen Leuchtmittelträgers 06 verschiedenen, elektrisch leitfähigen Fläche 08 handelt es sich um eine einen oder mehrere Reflektoren 11 bildende (Fig. 5a, Fig. 5b)), auf einer oder mehreren Partien der dem Leuchteninnenraum 02 zugewandten Oberfläche 12 (Fig. 1) des Leuchtengehäuses 01 angebrachte, reflektierende Beschichtung. Die dem Leuchteninnenraum 02 zugewandte Oberfläche 12 umfasst dabei die dem Leuchteninnenraum 02 zugewandte Seite des Leuchtengehäuses 01.

Das Pad 10 ist bevorzugt an dem Leuchtmittelträger 06 verbunden. Das Pad 10 steht dabei in elektrischem Kontakt mit wenigstens einer Leiterbahn 04, 05 des Leuchtmittelträgers 06. Das Pad 10 steht vorzugsweise mit einer für den elektrischen Betrieb wenigstens einer z.B. als LED 07 ausgeführten Lichtquelle der Kraftfahrzeugleuchte vorgesehenen Leiterbahn 04, 05 des Leuchtmittelträgers 06 in elektrischer Verbindung. Besonders bevorzugt handelt es sich hierbei um die masseführende Leiterbahn 04. Das Pad 10 ist beispielsweise auf den Leuchtmittelträger 06 und/oder auf wenigstens eine Leiterbahn 04, 05 des Leuchtmittelträgers 06 aufgeklebt.

Dem Pad 10 kann wenigstens eine in den Fig. 5a) und 5b) dargestellte Kontaktfläche 13 zugeordnet sein. Die Kontaktfläche 13 ist dem Pad 10 gegenüberliegend. Befindet sich das Pad 10 am Leuchtmittelträger 06, so befindet sich die Kontaktfläche an der elektrisch leitfähigen Fläche 08. Befindet sich das Pad 10 an der elektrisch leitfähigen Fläche 08, so befindet sich die Kontaktfläche am Leuchtmittelträger 06. Je nachdem, ob das Pad am Leuchtmittelträger 06 oder an der elektrisch leitfähigen Fläche 08 vorgesehen ist, ist die Kontaktfläche 13 dabei mit mindestens einer elektrisch leitfähigen Fläche 08 oder mit mindestens einer Leiterbahn 04, 05 des Leuchtmittelträgers 06 elektrisch verbunden. In den Fig. 1 bis 5 ist die Kontaktfläche mit der elektrisch leitenden Fläche 08 elektrisch verbunden.

An der dem Pad 10 gegenüberliegenden und mit diesem zusammenwirkenden Kontaktfläche 13 kann wie in den Fig. 4, Fig. 5a) und Fig. 5b) dargestellt mindestens ein dem Pad 10 zugeordneter Vorsprung 14 vorgesehen sein. Die Oberfläche des Vorsprungs 14 ist dabei wie die Kontaktfläche 13 selbst ebenfalls Teil der elektrisch leitfähigen Fläche 08. Der mindestens eine Vorsprung 14 drückt in montiertem Zustand der Kraftfahrzeugleuchte das Pad 10 ein (Fig. 4) oder schneidet in dieses ein. Hierdurch wird ein besonders zuverlässiger elektrischer Kontakt sichergestellt.

Die Erfindung ist insbesondere im Bereich der Herstellung von Kraftfahrzeugleuchten gewerblich anwendbar.

### Bezugszeichenliste

- 01: Leuchtengehäuse
- 02: Leuchteninnenraum
- 03: elektronisches Bauelement
- 04: Leiterbahn
- 05: Leiterbahn
- 06: Leuchtmittelträger
- 07: LED
- 08: von den Leiterbahnen verschiedene elektrisch leitfähige Fläche
- 09: elektrisch nicht leitfähige Fläche
- 10: Pad
- 11: Reflektor
- 12: dem Leuchteninnenraum zugewandte Oberfläche des Leuchtengehäuses
- 13: Kontaktfläche
- 14: Vorsprung

## Patentansprüche

1. Kraftfahrzeugleuchte mit einem durch ein Leuchtengehäuse (01) und eine dieses abschließende Lichtscheibe umschlossenen Leuchteninnenraum (02), der wenigstens ein elektronisches Bauelement (03, 07) beherbergt, das auf wenigstens einem mit Leiterbahnen (04, 05) versehenen Leuchtmittelträger (06) angeordnet und elektrisch kontaktiert ist, und der wenigstens eine von den Leiterbahnen (04, 05) des mindestens einen Leuchtmittelträgers (06) verschiedene, elektrisch leitfähige Fläche (08) beherbergt, welche in elektrischem Kontakt mit zumindest einer Leiterbahn (04, 05) des mindestens einen Leuchtmittelträgers (06) steht,
**gekennzeichnet durch**
mindestens ein den elektrischen Kontakt der zumindest einen von den Leiterbahnen (04, 05) des mindestens einen Leuchtmittelträgers (06) verschiedenen elektrisch leitfähigen Fläche (08) mit zumindest einer Leiterbahn (04, 05) des mindestens einen Leuchtmittelträgers (06) besorgendes elastisches, elektrisch leitfähiges Pad (10).

2. Kraftfahrzeugleuchte nach Anspruch 1,
**dadurch gekennzeichnet,**
**dass** das Pad (10) derart angeordnet ist, dass bei der Montage eines zumindest eine elektrisch leitfähige Fläche (08) umfassenden Bauteils (01, 11) und des mindestens einen Leuchtmittelträgers (06) der elektrische Kontakt zwangsweise hergestellt wird.

3. Kraftfahrzeugleuchte nach Anspruch 1 oder 2,
**dadurch gekennzeichnet,**
**dass** die mindestens eine von den Leiterbahnen (04, 05) des mindestens einen Leuchtmittelträgers (06) verschiedene elektrisch leitfähige Fläche (08) eine Beschichtung umfasst.

4. Kraftfahrzeugleuchte nach Anspruch 3
**dadurch gekennzeichnet,**
**dass** die Beschichtung eine für einen Reflektor (11) vorgesehene oder einen solchen bildende reflektierende Beschichtung umfasst.

5. Kraftfahrzeugleuchte nach einem der vorhergehenden Ansprüche,
**dadurch gekennzeichnet,**
**dass** der Leuchtmittelträger (06) eine Platine (PCB; Printed-Circuit-Board) umfasst.

6. Kraftfahrzeugleuchte nach einem der vorhergehenden Ansprüche,
**dadurch gekennzeichnet,**
**dass** der Leuchtmittelträger (06) einen in MID-Technik (MID; Molded Interconnect Device) hergestellten, spritzgegossenen Schaltungsträger umfasst.

7. Kraftfahrzeugleuchte nach einem der vorhergehenden Ansprüche,
**dadurch gekennzeichnet,**
**dass** der Leuchtmittelträger (06) einen Teil des Leuchtengehäuses (01) bildet, dieses umfasst oder von diesem umfasst wird.

8. Kraftfahrzeugleuchte nach einem der vorhergehenden Ansprüche,
**dadurch gekennzeichnet,**
**dass** das mindestens eine Pad (10) an der zumindest einen elektrisch leitfähigen Fläche (08) und/oder an wenigstens einer Leiterbahn (04, 05) des mindestens einen Leuchtmittelträgers (06) befestigt und mit dieser elektrisch verbunden ist.

9. Kraftfahrzeugleuchte nach Anspruch 8,
**dadurch gekennzeichnet,**
**dass** das Pad (10) aufgeklebt ist.

10. Kraftfahrzeugleuchte nach einem der vorhergehenden Ansprüche,
**dadurch gekennzeichnet,**
**dass** das Pad (10):
- aus einem elektrisch leitfähigen Schaum bzw. Schaumstoff, oder
- aus einem aufgeschäumten, elektrisch leitfähigen Werkstoff, oder
- aus einer elektrisch leitfähigen Paste, oder
- aus einem metallisierten Werkstoff, bevorzugt einem metallisierten Elastomer und besonders bevorzugt einem metallisiertes Gummi
hergestellt ist.

11. Kraftfahrzeugleuchte nach einem der vorhergehenden Ansprüche,
**dadurch gekennzeichnet,**
**dass** der Werkstoff des Pads (10) dauerelastisch oder dauerelastisch aushärtend ist.

12. Kraftfahrzeugleuchte nach einem der vorhergehenden Ansprüche,
**gekennzeichnet durch**
eine dem Pad (10) zugeordnete und mit diesem zusammenwirkende und dem Pad (10) zugehörig gegenüberliegende Kontaktfläche (13).

13. Kraftfahrzeugleuchte nach Anspruch 12,
**dadurch gekennzeichnet,**
**dass** an der dem Pad (10) gegenüberliegenden und mit diesem zusammenwirkenden Kontaktfläche (13) mindestens ein dem Pad (10) zugeordneter Vorsprung (14) vorgesehen ist, welcher in montiertem Zustand der Kraftfahrzeugleuchte das Pad (10) eindrückt oder in dieses einschneidet.

14. Kraftfahrzeugleuchte nach einem der vorhergehenden Ansprüche,
**dadurch gekennzeichnet,**
**dass** das Pad (10) mit einer für den elektrischen Betrieb wenigstens einer Lichtquelle der Kraftfahrzeugleuchte vorgesehenen Leiterbahn (04, 05) des Leuchtmittelträgers (06) verbunden ist.

15. Kraftfahrzeugleuchte nach einem der vorhergehenden Ansprüche,
**gekennzeichnet durch**
mindestens eine in dem Leuchteninnenraum (02) auf dem Leuchtmittelträger (06) angeordnete und elektrisch kontaktierte LED (07) als Lichtquelle.

## Claims

1. A motor vehicle lamp having a lamp interior (02) that is enclosed by a lamp housing (01) shut off by a lens, which lamp interior (02) accommodates at least one electronic component (03, 07) arranged on at least one lighting means carrier (06) provided with conductor paths (04, 05) and being electrically contacted, and which lamp interior (02) accommodates at least one electrically conductive surface (08) that is different from the conductor paths (04, 05) of the at least one lighting means carrier (06), said electrically conductive surface being in electrical contact with at least one conductor path (04, 05) of the at least one lighting means carrier (06), **characterized by** at least one elastic, electrically conductive pad (10) providing the electric contact of the at least one electrically conductive surface (08) that is different from the conductor paths (04, 05) of the at least one lighting means carrier (06) with at least one conductor path (04, 05) of the at least one lighting means (06).

2. The motor vehicle lamp as recited in claim 1, **characterized in that** the pad (10) is arranged in such a manner that the electric contact is inevitably produced on mounting a component (01, 11) comprising at least one electrically conductive surface (08) and the at least one lighting means carrier (06).

3. The motor vehicle lamp as recited in claim 1 or 2, **characterized in that** the at least one electrically conductive surface (08) that is different from the conductor paths (04, 05) of the at least one lighting means carrier (06) comprises a coating.

4. The motor vehicle lamp as recited in claim 3, **characterized in that** the coating comprises a reflective coating that is provided for a reflector or that forms such a reflector (11).

5. The motor vehicle lamp as recited in one of the previous claims, **characterized in that** the lighting means carrier (06) comprises a printed circuit board (PCB).

6. The motor vehicle lamp as recited in one of the previous claims, **characterized in that** the lighting means carrier (06) comprises an injection moulded interconnect device produced by way of MID technology (MID; molded interconnect device).

7. The motor vehicle lamp as recited in one of the previous claims, **characterized in that** the lighting means carrier (06) forms a part of the lamp housing (01), comprises the lamp housing (01), or is comprised by it.

8. The motor vehicle lamp as recited in one of the previous claims, **characterized in that** the at least one pad (10) is fastened to the at least one electrically conductive surface (08) and/or to at least one conductor path (04, 05) of the at least one lighting means carrier (06) and electrically connected thereto.

9. The motor vehicle lamp as recited in claim 8, **characterized in that** the pad (10) is glued on.

10. The motor vehicle lamp as recited in one of the previous claims, **characterized in that** the pad (10) is produced:
- from an electrically conductive foam or foam material, or
- from a foamed, electrically conductive material, or
- from an electrically conductive paste, or
- from a metallised material, preferably a metallised elastomer, and particularly preferably, a metallised rubber.

11. The motor vehicle lamp as recited in one of the previous claims, **characterized in that** the material of the pad (10) is permanently elastic or becomes permanently elastic after curing.

12. The motor vehicle lamp as recited in one of the previous claims, **characterized by** a contact surface (13) allocated to and interacting with the pad (10) and correspondingly positioned opposite the pad (10).

13. The motor vehicle lamp as recited in claim 12, **characterized in that** at least one projection (14) is associated with the pad (10), which projection (14) is provided at the contact surface (13) positioned opposite the pad (10) and interacting with the pad (10), and which projection presses or cuts into the pad (10) in the mounted state of the motor vehicle lamp.

14. The motor vehicle lamp as recited in one of the previous claims, **characterized in that** the pad (10) is connected to a conductor path (04, 05) of the lighting means carrier (06), which conductor path (04, 05) is provided for the electric operation of at least one light source of the motor vehicle lamp.

15. The motor vehicle lamp as recited in one of the previous claims, **characterized by** at least one electrically contacted LED (07) arranged in the lamp interior (02) on the lighting means (06) as a light source.

## Revendications

1. Lampe de véhicule automobile comprenant un volume intérieur de lampe (02) qui est entouré par un boîtier de lampe (01) et par une glace fermant ce dernier et qui loge au moins un composant électronique (03, 07) lequel est disposé sur au moins un support de moyen lumineux (06) pourvu de pistes conductrices (04, 05) et est contacté électriquement, et qui loge au moins une surface électriquement conductrice (08) laquelle est différente des pistes conductrices (04, 05) dudit au moins un support de moyen lumineux (06) et laquelle est en contact électrique avec au moins une piste conductrice (04, 05) dudit au moins un support de moyen lumineux (06), **caractérisée par** au moins un pad électriquement conducteur (10) élastique qui procure le contact électrique de ladite au moins une surface électriquement conductrice (08) différente des pistes conductrices (04, 05) dudit au moins un support de moyen lumineux (06), avec au moins une piste conductrice (04, 05) dudit au moins un support de moyen lumineux (06).

2. Lampe de véhicule automobile selon la revendication 1, **caractérisée par le fait que** ledit pad (10) est agencé de telle manière que, lors du montage d'un composant (01, 11) comprenant au moins une surface électriquement conductrice (08) et dudit au moins un support de moyen lumineux (06), le contact électrique est établi par force.

3. Lampe de véhicule automobile selon la revendication 1 ou 2, **caractérisée par le fait que** ladite au moins une surface électriquement conductrice (08) différente des pistes conductrices (04, 05) dudit au moins un support de moyen lumineux (06) comprend un revêtement.

4. Lampe de véhicule automobile selon la revendication 3, **caractérisée par le fait que** ledit revêtement comprend un revêtement réfléchissant prévu pour un réflecteur (11) ou formant un tel réflecteur.

5. Lampe de véhicule automobile selon l'une quelconque des revendications précédentes, **caractérisée par le fait que** ledit support de moyen lumineux (06) comprend une carte de circuits imprimés (PCB ; Printed circuit board).

6. Lampe de véhicule automobile selon l'une quelconque des revendications précédentes, **caractérisée par le fait que** ledit support de moyen lumineux (06) comprend un support de circuits moulé par injection fabriqué selon la technique MID (MID ; molded interconnect device).

7. Lampe de véhicule automobile selon l'une quelconque des revendications précédentes, **caractérisée par le fait que** ledit support de moyen lumineux (06) forme une partie dudit boîtier de lampe (01), comprend celui-ci ou est compris par celui-ci.

8. Lampe de véhicule automobile selon l'une quelconque des revendications précédentes, **caractérisée par le fait que** ledit au moins un pad (10) est fixé sur ladite au moins une surface électriquement conductrice (08) et/ou sur au moins une piste conductrice (04, 05) dudit au moins un support de moyen lumineux (06), et est connecté électriquement à celle-ci.

9. Lampe de véhicule automobile selon la revendication 8, **caractérisée par le fait que** ledit pad (10) est collé dessus.

10. Lampe de véhicule automobile selon l'une quelconque des revendications précédentes, **caractérisée par le fait que** ledit pad (10) est fabriqué :
- dans une mousse ou bien produit alvéolaire électriquement conductrice/conducteur ou
- dans un matériau électriquement conducteur moussé ou
- dans une pâte électriquement conductrice ou
- dans un matériau métallisé, de préférence un élastomère métallisé et, de manière particulièrement préférée, un caoutchouc métallisé.

11. Lampe de véhicule automobile selon l'une quelconque des revendications précédentes, **caractérisée par le fait que** le matériau dudit pad (10) est durablement élastique ou est durablement élastique après durcissement.

12. Lampe de véhicule automobile selon l'une quelconque des revendications précédentes, **caractérisée par** une surface de contact (13) qui est associée audit pad (10) et agit de concert avec celui-ci et est situé en regard dudit pad (10) en faisant partie de celui-ci.

13. Lampe de véhicule automobile selon la revendication 12, **caractérisée par le fait que** sur ladite surface de contact (13) située en regard du pad (10) et agissant de concert avec celui-ci est prévue au moins une projection (14) qui est associée au pad (10) et qui, en état monté de la lampe de véhicule automobile, enfonce le pad (10) ou coupe dans celui-ci.

14. Lampe de véhicule automobile selon l'une quelconque des revendications précédentes, **caractérisée par le fait que** ledit pad (10) est relié à une piste conductrice (04, 05) du support de moyen lumineux (06) qui est prévue pour le fonctionnement électrique d'au moins une source de lumière de la lampe de véhicule automobile.

15. Lampe de véhicule automobile selon l'une quelconque des revendications précédentes, **caractérisée par** au moins une LED (07) en tant que source de lumière, qui est disposée dans le volume intérieur de lampe (02) sur ledit support de moyen lumineux (06) et est contactée électriquement.
